(19) Europäisches Patentamt
European Patent Office
Office européen des brevets

(11) **EP 3 809 452 B1**

(12) **FASCICULE DE BREVET EUROPEEN**

(45) Date de publication et mention
de la délivrance du brevet:
**27.04.2022 Bulletin 2022/17**

(21) Numéro de dépôt: **20200050.1**

(22) Date de dépôt: **05.10.2020**

(51) Classification Internationale des Brevets (IPC):
***H01L 21/365*** $^{(2006.01)}$

(52) Classification Coopérative des Brevets (CPC):
**H01L 21/02433; H01L 21/02381; H01L 21/02485;
H01L 21/02568; H01L 21/0262**

(54) **PROCÉDÉ D'ÉPITAXIE DE SELENIURE DE GALLIUM (GASE) SUR UN SUBSTRAT DE SILICIUM D'ORIENTATION (111)**

VERFAHREN FÜR DIE EPITAXIE VON GALLIUMSELENID (GASE) AUF EINEM SILIZIUMSUBSTRAT MIT DER ORIENTIERUNG (111)

METHOD FOR EPITAXY OF GALLIUM SELENIDE (GASE) ON A SILICON SUBSTRATE ORIENTED (111)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.10.2019 FR 1911450**

(43) Date de publication de la demande:
**21.04.2021 Bulletin 2021/16**

(73) Titulaires:
• **Commissariat à l'Energie Atomique et aux Energies Alternatives**
**75015 Paris (FR)**
• **Centre national de la recherche scientifique**
**75016 Paris (FR)**
• **Université Grenoble Alpes**
**38401 Saint-Martin-d'Hères (FR)**

(72) Inventeurs:
• **MARTIN, Mickaël**
**38000 GRENOBLE (FR)**
• **BARON, Thierry**
**38120 SAINT-EGREVE (FR)**

(74) Mandataire: **Marks & Clerk France**
**Immeuble "Visium"**
**22, avenue Aristide Briand**
**94117 Arcueil Cedex (FR)**

(56) Documents cités:
• **PALMER J E ET AL: "LAYERED STRUCTURE GASE AS A THERMAL LATTICE MISMATCH BUFFER LAYER IN THE GAAS/SIHETEROEPITAXIAL SYSTEM", EXTENDED ABSTRACTS OF THE INTERNATIONAL CONFERENCE ON SOLIDSTATE DEVICES AND MATERIALS, JAPAN SOCIETY OF APPLIED PHYSICS. TOKYO, JA, 26 août 1992 (1992-08-26), pages 302-303, XP000312221,**
• **LE THANH VINH ET AL: "HETEROEPITAXY OF GASE LAYERED SEMICONDUCTOR COMPOUND ON SI(111)7X7 SUBSTRATE: A VAN DER WAALS EPITAXY?", JOURNAL OF CRYSTAL GROWTH, ELSEVIER, AMSTERDAM, NL, vol. 135, no. 1/02, 1994, pages 1-10, XP000486360, ISSN: 0022-0248, DOI: 10.1016/0022-0248(94)90719-6**

## Description

## Domaine technique de l'invention

L'invention se situe dans le domaine de l'hétéro-intégration de matériaux semi-conducteurs sur substrat de silicium, et concerne plus précisément l'épitaxie du séléniure de gallium bidimensionnel (GaSe-2D) avec une orientation unique sur substrat de silicium d'orientation [111], qui peut être désigné par Si(111).

Parmi les nombreuses applications de l'invention, on peut citer la microélectronique, la photonique, les capteurs, les technologies en relation avec la radiofréquence, les microsystèmes (MEMS), les composants pour l'internet des objets (Internet of Things) et plus largement tout ce qui touche aux applications « more than Moore » ou technologies dites dérivées, c'est-à-dire les technologies qui intègrent plusieurs fonctions sur une même puce de silicium.

## Etat de la technique

Le silicium (Si) est le semi-conducteur de base en micro-nanoélectronique. Sa technologie hautement mature pour la fabrication de circuits intégrés (IC) a connu des progrès impressionnants en termes de miniaturisation et d'amélioration des performances.

Cependant, d'autres semi-conducteurs présentent des propriétés complémentaires (électronique, optique, mécanique...) qu'il peut être intéressant d'implémenter sur les puces à base de silicium.

Dans ce contexte, une nouvelle classe de matériaux a récemment fait son apparition : les « matériaux 2D ». Par matériau 2D, on entend un matériau constitué d'un feuillet (ou d'un empilement de feuillets) de quelques atomes d'épaisseur. On parle aussi de matériau « bidimensionnel ». Ces matériaux sont saturés électroniquement, l'empilement de plusieurs de ces feuillets se fait donc via des liaisons de van der Waals. Parmi les matériaux 2D, certains sont semi-conducteurs. Leur très faible épaisseur donne naissance à des propriétés électroniques, optoélectroniques et mécaniques tout à fait singulières. Un matériau, qui n'est pas structuré en feuillet(s) mais avec des liaisons ioniques ou covalentes dans tout son volume peut aussi être désigné par « matériau 3D », par exemple un matériau semi-conducteur traditionnel.

L'hétéro-intégration monolithique de matériaux 2D par épitaxie sur substrat de silicium est une voie très prometteuse pour ajouter de nouvelles fonctionnalités (électroniques, optiques, photoniques, mécaniques, biologiques...) aux circuits intégrés CMOS (Complementary Metal Oxide Semiconductor) de technologie hautement mature basée sur le silicium. Elle permet également de s'affranchir de la difficile problématique des dislocations du réseau cristallin des semi-conducteurs plus classiques (Ge, III-V, GaN...) épitaxiés sur silicium.

Parmi tous les matériaux 2D, le séléniure de gallium, désigné GaSe, est un matériau très intéressant pour l'épitaxie sur un substrat de silicium d'orientation [111] dans la mesure où les liaisons pendantes de la surface de silicium peuvent être passivées électroniquement par un plan atomique de gallium (Ga) et un plan atomique de sélénium (Se) pour former une interface Si-Ga-Se stable et passivée électroniquement permettant la croissance ultérieure du matériau GaSe bidimensionnel (dénommé « GaSe-2D » ou « GaSe 2D ») par épitaxie de van der Waals. Le biplan atomique de gallium et de sélénium peut être formé en utilisant la technique d'épitaxie par jets moléculaires dite « MBE » (pour « Molecular Beam Epitaxy » en anglais) consistant à envoyer un ou plusieurs jets moléculaires vers le substrat.

Par « passivé électroniquement », ou « passivation électronique », on entend la suppression de liaisons pendantes (ou des liaisons réactives Si-H dans un environnement hydrogéné). On peut également parler de surface saturée électroniquement.

Un plan atomique de gallium ainsi lié à un plan atomique de sélénium, peut être nommé « biplan atomique » et peut être vu comme un demi-feuillet du matériau « GaSe-2D ». En effet, le GaSe-2D désigne le séléniure de gallium bidimensionnel (en feuillet) constitué de quatre plans atomiques de séquence Se-Ga-Ga-Se.

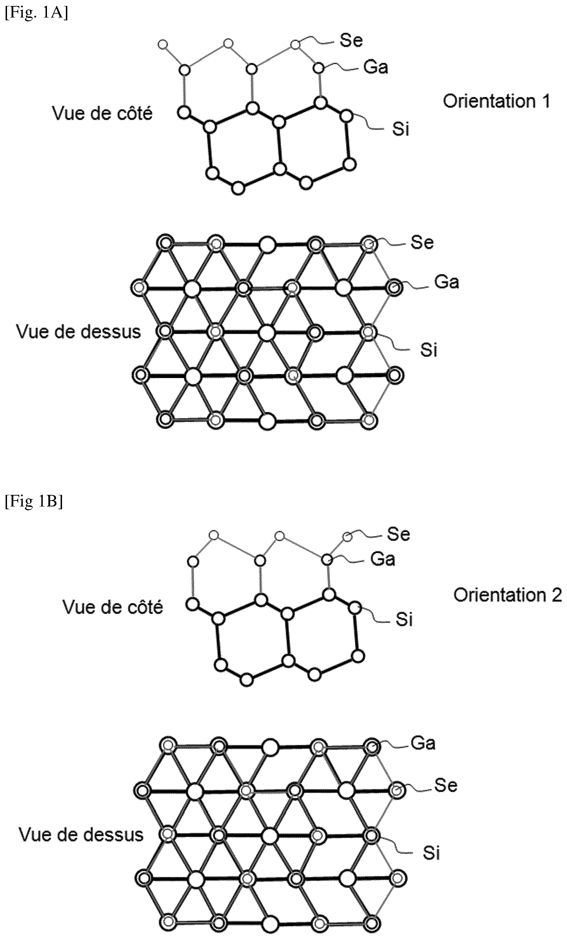

Cependant, la formation de l'interface Si-Ga-Se peut conduire à une surface avec deux types de domaines en symétrie miroir l'un par rapport à l'autre, conduisant à un défaut d'antiphase comme illustré dans les figures 1A (orientation 1) et 1B (orientation 2).

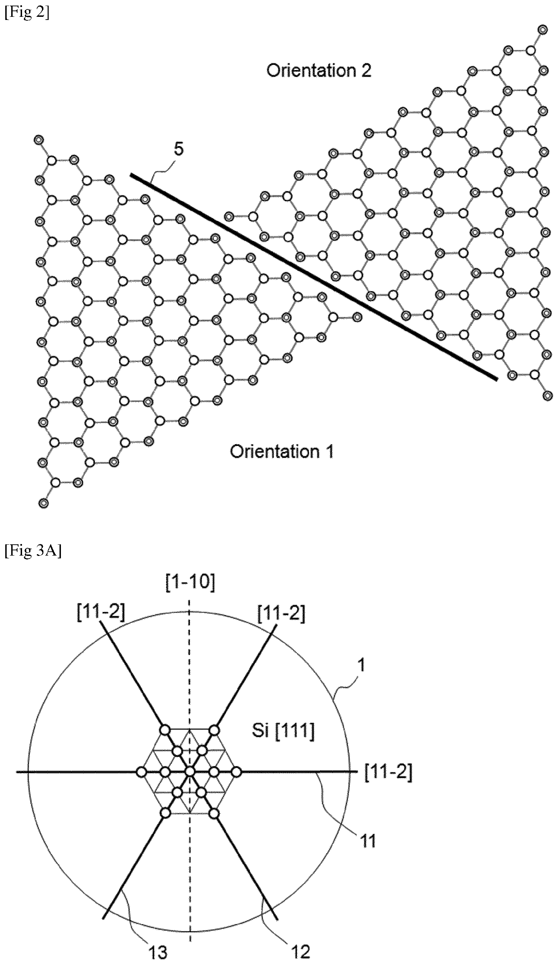

La croissance épitaxiale ultérieure du matériau GaSe-2D sur cette interface Si-Ga-Se, et plus précisément sur cette surface avec des domaines en symétrie miroir 5, peut conduire également à la formation de grains de GaSe avec deux orientations à 180° l'une par rapport à l'autre, comme illustré en figure 2. Lors de la coalescence de ces grains de GaSe, des défauts cristallins vont se former (joints de grain), et ces défauts cristallins peuvent endommager les propriétés optiques, électroniques, thermiques et mécaniques du matériau GaSe 2D.

De manière générale, les techniques de croissance du GaSe-2D utilisées dans l'état de l'art sont sensibles aux différentes orientations de la surface Si(111) passivée. Les couches de GaSe-2D ainsi obtenues contiennent ainsi toujours deux types de domaines, en symétrie miroir, séparés par des joints de grain, entrainant des défauts cristallins.

Les deux documents suivants divulguent des méthodes de formation de couches de GaSe sur des substrats de silicium :

Extended Abstracts of the 1992 International Conference on Solid State Devices and Materials, Tsukuba, 1992, pages 302-303; and
Journal of Crystal Growth vol. 135 (1994), pages 1-10

L'invention vise à disposer d'un procédé d'épitaxie de séléniure de gallium sur un substrat de silicium d'orientation [111] sans les inconvénients précités de l'art antérieur.

Plus particulièrement, elle vise à disposer d'un procédé d'épitaxie de séléniure de gallium 2D sur un substrat de silicium d'orientation [111] qui permette de réduire les défauts générés à l'interface entre ledit substrat de silicium et ladite couche de GaSe-2D épitaxiée, en particulier de réduire la formation de parois d'antiphase, et qui soit industrialisable, c'est-à-dire simple à mettre en œuvre, à large échelle (substrat de 200 et 300 mm) et avec un haut rendement de fabrication.

**Expose de l'invention**

Un procédé permettant de remédier à ces inconvénients est un procédé d'épitaxie de GaSe sur un substrat de silicium d'orientation [111] caractérisé en ce qu'il comprend :

- une étape de sélection d'un substrat de silicium d'orientation [111], ledit substrat provenant d'une découpe d'un barreau de silicium selon une direction de désorientation qui est une des trois directions cristallographiques [11-2], l'angle de désorientation étant inférieur ou égal à 0,1°, la surface du substrat obtenue formant une surface vicinale présentant une pluralité de terrasses et au moins une marche entre deux terrasses ;
- une étape de passivation consistant en un dépôt d'un biplan atomique de gallium et de sélénium sur la surface vicinale du substrat de silicium de manière à former une surface vicinale passivée en silicium-gallium-sélénium, ladite surface vicinale passivée présentant une pluralité de terrasses passivées et au moins une marche passivée entre deux terrasses passivées ;
- une étape de formation d'une couche de GaSe bidimensionnel par épitaxie sur la surface vicinale passivée, ladite étape de formation comprenant une étape de nucléation à partir de chaque marche passivée et une étape de croissance latérale sur les terrasses passivées des nuclei obtenus lors de l'étape de nucléation.

Par « angle de désorientation étant inférieur ou égal à 0,1° », on entend que la valeur absolue de l'angle de désorientation est inférieure ou égale à 0,1°, en d'autres termes, l'angle de désorientation est compris entre -0,1° et +0,1°, incluant les valeurs -0,1° et +0,1°.

Par « croissance latérale », on entend que chaque nuclei croit à partir de la marche dans une direction opposée à ladite marche et selon le plan principal de la terrasse.

Le procédé combine une sélection précise d'un substrat de Si(111) qui a été découpé selon des spécifications précises, ce qui permet d'obtenir une surface vicinale, avec des conditions de croissance épitaxiale du GaSe permettant une nucléation préférentielle du GaSe-2D par alignement à partir des marches de la surface vicinale.

Une surface vicinale est une surface sur laquelle les atomes ne sont plus répartis dans un plan mais s'organisent en un réseau de marches régulièrement espacées dont la hauteur est un multiple de la distance entre deux plans successifs d'atomes du réseau cristallin du matériau. Cette surface se présente comme une succession de terrasses et de marches entre les terrasses. Les marches sont idéalement rectilignes et parallèles, et ce, en fonction des conditions de découpe du matériau.

Le procédé comprend ainsi la sélection d'un substrat de silicium d'orientation [111] provenant d'un barreau cylindrique de silicium d'orientation [111]. La face orientée [111] du silicium est un plan dense. La surface vicinale du substrat est obtenue en partant dudit barreau cylindrique de silicium d'orientation [111] et en le découpant selon un plan cristallographique faiblement désorienté par rapport au plan dense [111], c'est-à-dire dont l'angle de désorientation est inférieur ou égal à 0,1°.

L'étape de sélection peut comprendre une étape de contrôle de ces spécifications de découpe sur le substrat sélectionné. L'étape de contrôle du substrat peut comprendre une étape de mesure du substrat par diffraction X qui permet d'obtenir les caractéristiques de désorientation du substrat

La découpe doit être réalisée de manière à orienter la direction d'alignement des marches, permettant ainsi de conditionner la croissance du GaSe-2D à partir ces marches dans l'étape de formation de la couche de GaSe-2D. Cela permet une nucléation préférentielle du GaSe-2D à partir des marches plutôt qu'au sein des terrasses. En effet, l'orientation de la couche de GaSe-2D va être imposée par la direction d'alignement des marches.

Lors de l'étape de formation de la couche de GaSe-2D par épitaxie, par exemple pendant l'étape de nucléation ou après celle-ci, il est possible de rajouter une étape de contrôle de l'alignement des nuclei de GaSe contre les marches. Cette étape de contrôle de l'alignement peut comprendre une étape de mesure par microscope électronique en transmission à balayage (ou « STEM » en anglais pour « Scanning Transmission Electron Microscopy ») à haute résolution qui permet de vérifier la présence de liaisons covalentes des atomes de GaSe au niveau des marches.

Au final, la combinaison de l'étape de sélection et de l'étape de formation de la couche de GaSe-2D permet d'obtenir une couche de GaSe-2D d'orientation unique permettant de s'affranchir de la problématique des joints de grain. Cette couche de Ga-Se-2D, de très faible défectivité, peut ensuite être utilisée en tant que couche active pour des dispositifs sur silicium avec de nouvelles fonctionnalités (électroniques, optoélectroniques, mécaniques...).

Selon un mode de réalisation, le procédé comprend en outre une étape de traitement de la surface vicinale de manière à aplanir les terrasses de ladite surface vicinale jusqu'à obtenir une rugosité sensiblement nulle sur les terrasses, ladite étape de traitement étant réalisée après l'étape de sélection du substrat et avant l'étape de passivation.

L'étape de traitement peut consister en un traitement thermique du substrat de silicium à haute température, de préférence supérieure à 800°C. La pression pendant le traitement thermique est de préférence inférieure à 800 hPa (600 Torr).

Selon un mode de réalisation, l'étape de passivation consiste en un dépôt en phase vapeur avec des précurseurs organométalliques (MOCVD). En particulier, les précurseurs organométalliques peuvent être le TriMéthylGallium (TMGa) et le Di-isoPropylSelenium (DiPSe). La pression partielle de TMGa est de préférence comprise entre 0,13 et 26,7 Pa (1 et 200 mTorr). L'étape de passivation est de préférence réalisée à une température comprise entre 400 et 650°C. L'étape de passivation est de préférence réalisée pendant une durée comprise entre 2 et 30 secondes.

Selon un mode de réalisation, l'étape de nucléation consiste en un dépôt en phase vapeur avec des précurseurs organométalliques. La pression partielle du précurseur du gallium est de préférence inférieure ou égale à 6,7 Pa (50 mTorr).

L'étape de nucléation est de préférence réalisée à une température comprise entre 400 et 650°C. L'étape de nucléation est de préférence réalisée pendant une durée comprise entre 2 et 30 secondes.

Selon un mode de réalisation, l'étape de croissance latérale consiste en un dépôt en phase vapeur avec des précurseurs organométalliques. La pression partielle du précurseur du gallium est de préférence comprise entre 0,067 et 0,67 Pa (0,5 et 5 mTorr).

L'étape de croissance latérale est de préférence réalisée à une température comprise entre 570 et 650°C.

Selon un mode de réalisation, le procédé comprend en outre une étape de retrait de l'oxyde de la surface vicinale, ladite étape de désoxydation étant réalisée après l'étape de sélection du substrat et avant l'étape de passivation.

Selon un mode de réalisation, le procédé comprend en outre une étape supplémentaire d'épitaxie d'au moins un matériau 2D autre que le GaSe-2D ou d'au moins un matériau semi-conducteur 3D, ladite étape supplémentaire d'épitaxie étant formée sur la couche de GaSe-2D.

Ainsi, la couche de GaSe-2D obtenue par le procédé selon l'invention peut servir de couche tampon de haute qualité pour la croissance ultérieure d'autres matériaux et ce, avec une faible défectivité. Le au moins un matériau 2D autre que le GaSe-2D ou le au moins un matériau 3D peut être choisi parmi les matériaux III-VI tels que le InSe, GaS, GaTe ou une combinaison de matériaux III-VI, les matériaux III-V tels que le GaN, InGaN, GaAs, GaSb ou une combinaison de matériaux III-V, les matériaux II-VI tels que CdHgTe ou une combinaison de matériaux II-VI, ou encore les matériaux IV-IV tels que SiGe ou Ge-Ge ou une combinaison de matériaux IV-IV.

Le procédé permet ainsi de réaliser une épitaxie par avancée à partir de chaque marche d'une surface vicinale de silicium Si(111) de manière à obtenir une couche de GaSe 2D à orientation unique sans joints de grain.

Le procédé permet au final de réaliser une orientation unique du GaSe 2D sans défauts d'antiphase, et ce avec un procédé industriel réalisable à large échelle, à haut rendement, notamment par MOCVD sur substrat compatible avec les moyens standards de micro/nanofabrication d'une plateforme technologique Silicium.

Un autre objet de l'invention est la structure obtenue par le procédé d'épitaxie comprenant :

- un substrat de silicium d'orientation [111] dont la surface est une surface vicinale passivée présentant des terrasses passivées et au moins une marche passivée entre deux terrasses passivées ;
- une couche de GaSe-2D formée sur les terrasses passivées, et présentant une orientation unique sans parois d'antiphase.

L'angle de désorientation de la surface vicinale du substrat de silicium d'orientation [111] est inférieur ou égal à 0,1°.

De préférence, la direction [11-2] de la surface de silicium est alignée avec la direction [11-20] du GaSe.

**Brève description des figures**

D'autres caractéristiques et avantages de l'invention apparaîtront à l'aide de la description qui suit, donnée à titre illustratif et non limitatif, faite en regard des figures annexées parmi lesquelles

[Fig.IA]

[Fig.IB] illustrent une surface de Si-Ga-Se avec deux orientations opposées.

[Fig.2] illustre la formation de grains de GaSe 2D avec deux orientations à 180° l'une par rapport à l'autre.

[Fig.3A],

[Fig.3B],

[Fig.3C],

[Fig.3D],

[Fig.3E],

[Fig.3F],

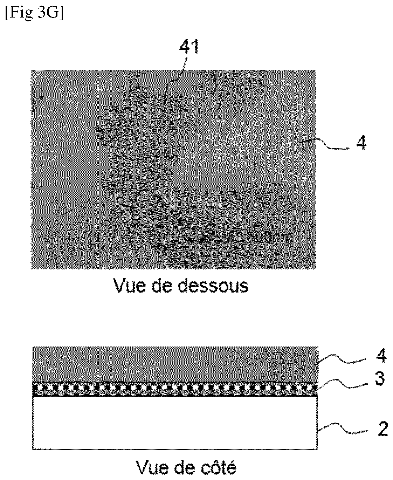

[Fig.3G] représentent un exemple de procédé d'épitaxie de GaSe 2D sur un substrat Si(111) selon l'invention.

## Description détaillée de l'invention

Les figures 1A, 1B et 2 ont été décrites précédemment et ne seront pas reprises ici.

Les figures 3A à 3G représentent un exemple de procédé d'épitaxie de GaSe 2D sur un substrat Si(111) selon l'invention.

La première étape du procédé est une étape de sélection qui consiste à sélectionner un substrat de silicium d'orientation [111] obtenu à partir d'un barreau 1 de cristal de silicium découpé en tranches selon des spécifications de découpe adaptées pour obtenir une surface vicinale 2 de silicium d'orientation [111], que l'on pourra également nommer « substrat de Si(111) vicinal ».

Plus précisément, le substrat de Si(111) vicinal est réalisé en découpant le barreau de silicium selon une direction de désorientation 11, 12, 13 (couramment désignée par les termes « miscut direction » en anglais) du substrat qui soit précisément selon l'une des trois directions cristallographiques équivalentes [11-2]. En d'autres termes, la découpe du cristal de silicium est réalisée selon l'un des angles azimutaux suivants : 90°, 30° ou -30° par rapport à la direction de la marque de l'orientation du réseau cristallin [1-10] (couramment désignée par le terme « notch » en anglais) du substrat.

La figure 3A illustre les trois directions cristallographiques équivalentes [11-2] en vue de dessus du barreau 1 de cristal de silicium Si(111). Le barreau peut par exemple être découpé selon la direction 11 qui correspond à l'une des trois directions cristallographiques équivalentes [11-2].

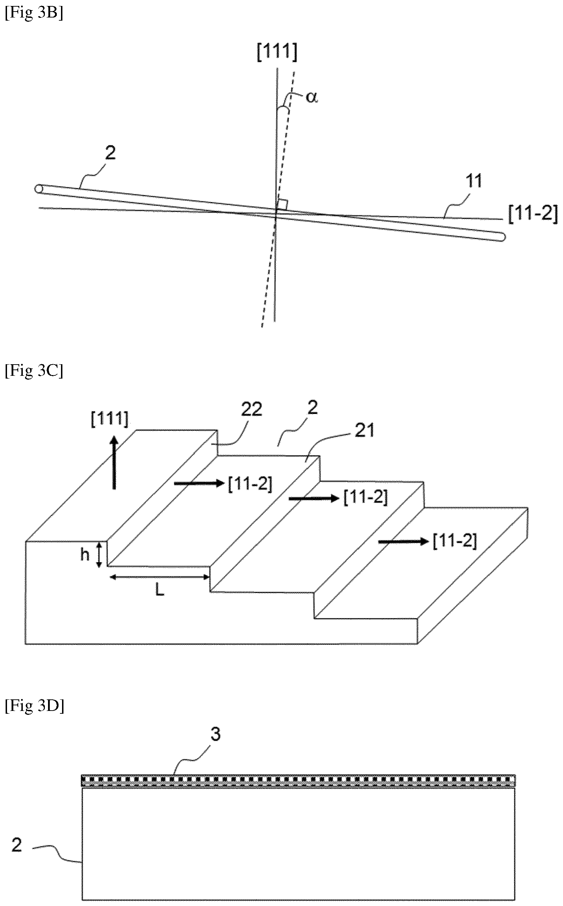

La figure 3B illustre les paramètres de désorientation. La désorientation du cristal est définie par un angle de désorientation $\alpha$ (couramment désigné par les termes « miscut angle » en anglais), qui définit l'angle entre la normale de la surface vicinale 2 et la direction [111].

Comme indiqué dans l'exposé de l'invention, dans une surface vicinale, les atomes ne sont pas répartis dans un plan mais s'organisent en un réseau de terrasses et au moins une marche espacée par deux terrasses. La hauteur d'une marche est un multiple de la distance entre deux plans successifs d'atomes. Ainsi la surface vicinale 2 illustrée se présente comme une succession de terrasses 21 et d'au moins une marche 22 entre deux terrasses. La largeur L des terrasses correspond à la dimension selon la direction cristallographique [11-2] choisie pour la découpe. La hauteur h d'une marche correspond à la dimension selon la direction cristallographique [111].

L'angle de désorientation $\alpha$ permet de déterminer la largeur L des terrasses 21, par la formule suivante :

[Math1]

$$L = h / (\tan \alpha)$$

où h est la hauteur des marches.

La hauteur d'une marche est d'environ 0,3 nm dans le cas du Si(111).

La désorientation du cristal est également définie par la direction de désorientation qui est l'une des trois directions cristallographiques [11-2], comme indiqué précédemment.

De plus, pour avoir de larges terrasses et donc une faible densité de marche, l'angle de désorientation est choisi inférieur ou égal à 0,1°. Une faible densité de marches favorise une faible densité de nuclei limitant ainsi les potentiels défauts pouvant se produire lors de l'étape de nucléation du GaSe (dislocation notamment). Par « faible densité » de marche, on entend généralement une marche pour une largeur de terrasse de 200 nanomètres au moins.

On obtient ainsi un substrat Si(111) à surface vicinale faiblement désorienté, c'est-à-dire avec un angle de désorientation inférieur ou égal à 0,1°.

Après l'étape de sélection et avant l'étape de traitement décrite ci-après, le procédé peut comprendre une étape de retrait de l'oxyde de la surface de silicium (111), par exemple un traitement par voie humide avec du fluorure d'hydrogène (HF) ou par plasma dans une chambre de désoxydation de type Siconi™.

La seconde étape du procédé est une étape de traitement qui consiste en un traitement de la surface vicinale 2 obtenue de manière à aplanir les terrasses 21 orientées [111]. Cela permet de faire apparaitre les marches précisément orientées dans la direction [11-2], comme illustré en figure 3C. Cette étape de traitement, réalisée à haute température, consiste à faire diffuser en surface les atomes de silicium jusqu'à leur position d'équilibre de façon à révéler les plans de silicium d'orientation [111] de plus basse énergie. La rugosité résiduelle des terrasses orientées [111] du substrat de silicium après découpe et polissage chimique et mécanique (ou « CMP » pour « Chemical Mechanical Polishing » en anglais) est ainsi amenée à une valeur proche de zéro.

Cette étape de traitement est réalisée typiquement en introduisant le substrat dans une chambre d'épitaxie. Un gaz est introduit, par exemple de l'hydrogène. Alternativement, il peut s'agir de d'hélium, d'argon ou de tout autre gaz inerte de la colonne VIII du tableau périodique.

L'étape de traitement est généralement réalisée entre 800°C et 1100°C.

La pression dans la chambre peut être comprise dans une large gamme, par exemple entre 0,13 Pa et 100 kPa (1 mTorr et 750 Torr), voire entre 0,13 Pa et 80 kPa (1 mTorr et 600 Torr). De préférence, la pression de la chambre est basse, c'est-à-dire typiquement inférieure à 2,7 kPa (20 Torr), de préférence inférieure à 1,3 kPa (10 Torr). Une basse pression évite que le silicium commence à être gravé avec le gaz, notamment l'hydrogène, et ainsi cela évite la formation de lacunes en surface du silicium.

La durée de traitement est généralement comprise entre 5 et 30 minutes.

Selon un exemple de réalisation particulier, les conditions de l'étape de traitement sont :

- pression dans la chambre : 0,67-1,3 kPa (5-10 Torr) ;
- température : 900°C ;
- durée de traitement : 10 minutes.

La troisième étape du procédé est une étape de passivation de la surface de Si(111) vicinale, et ce, en déposant un biplan atomique de gallium et de sélénium, c'est-à-dire un plan atomique de gallium (Ga) et un plan atomique de sélénium (Se), sur la surface de Si(111). Cela permet d'obtenir la formation d'une surface vicinale passivée 3 en Si-Ga-Se, telle qu'illustrée en figure 3D. Les liaisons hydrogénées Si-H, très réactives, en surface du Si(111) sont en effet remplacées par des liaisons Si-Ga-Se stables à haute température (jusqu'à environ 650-750°C) et passivées électroniquement, c'est-à-dire que la couche de valence des atomes en surface est pleine (les électrons de valence sont appariés). Cette surface passivée, de très faible énergie, permet ensuite l'épitaxie d'un matériau 2D sans liaisons covalentes avec les terrasses 21 du substrat de silicium [111], comme décrit plus après. Le biplan de passivation en GaSe constitué d'un plan atomique de Ga lié à un plan atomique de Se correspond aussi à un demi-feuillet du matériau GaSe 2D, un feuillet étant constitué d'une séquence de quatre plans atomiques Se-Ga-Ga-Se. Le GaSe 2D désigne le séléniure de gallium structuré en feuillet(s).

Selon l'invention, lorsqu'on parle d'une surface « passivée électroniquement », ou de « passivation électronique » de surface, on entend une surface stable et inerte chimiquement même à haute température (jusqu'à environ 650-750°C) avec des atomes possédant une couche de valence pleine. On peut également parler de surface saturée électroniquement.

Pour réaliser cette étape de passivation, le substrat de Si(111) est maintenu dans la chambre d'épitaxie et le demi-feuillet de GaSe est déposé par la technique de dépôt en phase vapeur aux organométalliques dite « MOCVD » (pour « Metal Organic Chemical Vapour Déposition » en anglais). La technique MOCVD est effectuée par transport de précurseurs organométalliques dans la chambre d'épitaxie via un gaz vecteur.

Pour obtenir le demi-feuillet GaSe en MOCVD, on introduit simultanément dans la chambre des précurseurs organométalliques, qui sont typiquement le TriMéthylGallium (TMGa) et le Di-isoPropylSelenium (DiPSe) qui sont gazeux à la température d'utilisation dans le procédé. Alternativement, il peut s'agir de tout autre précurseur de gallium et/ou de tout autre précurseur de sélénium.

Le gaz vecteur est typiquement de l'hydrogène. Alternativement, il peut s'agir de l'azote, ou d'un gaz inerte de la colonne VIII du tableau périodique.

L'étape de passivation est généralement réalisée entre 400°C et 650°C.

La pression totale dans la chambre dépend de l'équipement mais a des valeurs typiquement comprises entre 0,67 et 26,7 kPa (5 et 200 Torr).

La pression partielle du précurseur gallium est généralement comprise entre 0,13 et 26,7 Pa (1 et 200 mTorr).

Le rapport de flux molaire III/VI (précurseur groupe III/précurseur groupe VI) est généralement compris entre 1 et 10.

La durée de l'étape de passivation est généralement comprise entre 2 et 30 secondes.

Selon un exemple de réalisation particulier, les conditions de l'étape de passivation sont :

- pression totale dans la chambre 1,3-2,7 kPa (10-20 Torr);
- pression partielle de TMGa : environ 1,3 Pa (10 ;
- rapport flux molaire Se/Ga (VI/III) : environ 3-4 ;
- température : 530-550°C ;
- durée de passivation t : entre 2 et 5 secondes.

Le demi-feuillet de GaSe pour obtenir la surface de passivation présente une épaisseur de l'ordre de 2 Å.

La technique MOCVD est avantageuse car elle permet une bonne reproductibilité, une bonne uniformité à l'échelle du substrat et des fortes vitesses de croissance cristalline. Elle est donc compatible avec les applications industrielles.

Alternativement, on peut utiliser d'autres techniques de dépôt en phase vapeur dite « CVD » (pour « Chemical Vapour Déposition » en anglais) telle que le dépôt chimique en phase vapeur assisté par plasma (PECVD pour « Plasma-Enhanced Chemical Vapor Déposition » en anglais), le dépôt de couches minces atomiques (ALD pour « Atomic Layer Déposition » en anglais) ou encore l'épitaxie HVPE pour « Hydride Vapour Phase Epitaxy » en anglais.

Encore alternativement, on peut utiliser la technique d'épitaxie par jets moléculaires dite « MBE » (pour « Molecular Beam Epitaxy » en anglais) consistant à envoyer un ou plusieurs jets moléculaires vers le substrat pour réaliser une croissance épitaxiale.

La quatrième étape du procédé est une étape de formation d'une couche de GaSe-2D sur la surface vicinale passivée. Elle consiste à faire croitre du GaSe de manière bidimensionnel (pour obtenir effectivement une couche de GaSe-2D) sur la surface passivée 3. Elle consiste ainsi en une épitaxie qui comprend une étape de nucléation et une étape de croissance latérale des nuclei jusqu'à former une couche tampon continue. Les étapes de nucléation et de croissance latérale sont décrites ci-après.

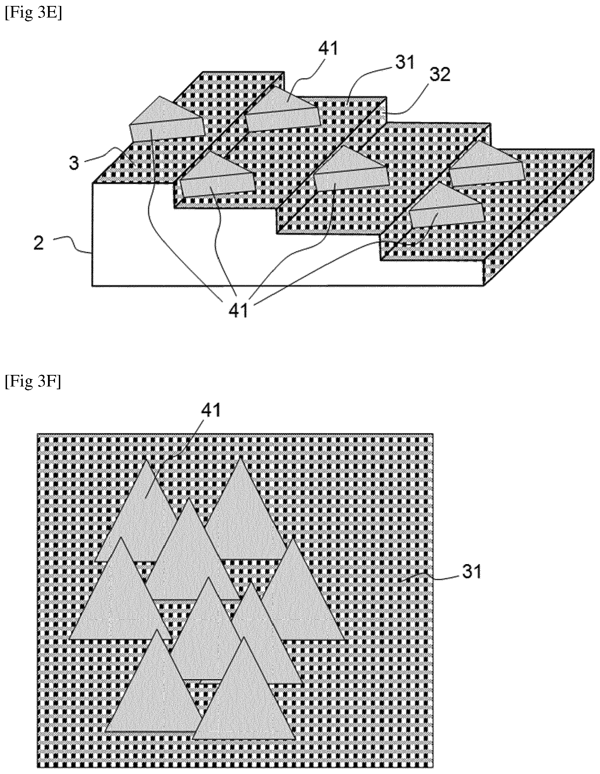

L'étape de nucléation est réalisée par le dépôt de grains (ou nuclei) 41 de GaSe sur la surface de passivation, comme illustré en figure 3E, et plus précisément sur la surface d'une terrasse contre la marche de cette terrasse. Les nuclei 41 de GaSe présentent une largeur initiale typiquement comprise entre 1 et 20 nanomètres.

Pour réaliser la nucléation, le substrat est maintenu dans la chambre de croissance et la technique MOCVD est utilisée. Les précurseurs pouvant être utilisés sont les mêmes que pour l'étape de passivation. Les pressions mises en œuvre sont inférieures à celles de l'étape de passivation.

Le gaz vecteur est typiquement de l'hydrogène. Alternativement, il peut s'agir de l'azote, de l'hélium, ou encore tout autre gaz inerte de la colonne VIII du tableau périodique.

Pour favoriser la nucléation contre les marches plutôt qu'au sein des terrasses, la pression partielle de précurseur (TMGa par exemple) est avantageusement faible ou modérée (inférieure ou égale à 6,7 Pa) afin de minimiser la rencontre des atomes de Ga et Se entre eux au sein des terrasses plutôt que contre les marches, et la température est suffisamment élevée (au moins 400°C mais de préférence au moins 500°C pour permettre la diffusion de surface des atomes jusqu'aux marches). Ainsi, l'étape de nucléation est généralement réalisée entre 400°C et 650°C.

La pression totale est adaptée en fonction de la géométrie de la chambre, mais des valeurs typiques sont comprises entre 0,67 et 11 kPa (5 et 80 Torr).

La pression partielle du précurseur gallium est généralement comprise entre 0,13 et 6,7 Pa (1 et 50 mTorr).

Le rapport de flux molaire VI/III dépendra du type de précurseur, des valeurs typiques sont comprises entre 4 et 5,3 hPa (3 et 4 Torr).

La durée de l'étape de nucléation est généralement comprise entre 2 et 30 secondes.

Ces conditions sont ainsi choisies de manière à promouvoir la diffusion et l'attachement des atomes de Ga et de Se à partir des marches, configuration d'énergie minimale. La croissance du GaSe-2D peut ainsi s'amorcer préférentiellement à partir des marches plutôt que de manière non contrôlée sur les terrasses comme par exemple au milieu des terrasses.

Au cours de cette étape de nucléation, les nuclei de GaSe vont s'aligner à partir des marches avec une orientation unique, et précisément avec la direction [11-2] de la surface de silicium alignée avec la direction [11-20] du GaSe ($[11\text{-}2]_{Si}//[11\text{-}20]_{GaSe}$).

Selon un exemple de réalisation particulier, les conditions de l'étape de nucléation sont les suivantes :

- pression totale de la chambre : 0,67-2,7 kPa (5-20 Torr) ;
- pression partielle de TMGa : environ 2,7-4 hPa (2-3 mTorr);
- rapport flux molaire Se/Ga (VI/III) : environ 3-4 ;

- température : 530-550°C ;
- durée de nucléation : 2-15 secondes.

L'étape de croissance latérale des grains de GaSe consiste à faire croitre latéralement, par rapport au plan de la terrasse sur laquelle les grains ont été déposés, les grains 41 de GaSe déposés lors de l'étape de nucléation, et ce, sur plusieurs microns, comme illustré sur les figures 3F et 3G, jusqu'à faire coalescer les grains en une couche continue 4, d'orientation unique sans joints de grain.

L'étape de croissance latérale des grains de GaSe est réalisée à plus faible pression partielle et plus haute température que l'étape de nucléation.

Le substrat est maintenu dans la chambre de croissance.

L'étape de croissance latérale est généralement réalisée entre 570°C et 650°C.

La pression totale dépend de l'équipement utilisé mais des valeurs typiques sont comprises entre 0,67 et 11 kPa (5 et 80 Torr).

La pression partielle des précurseurs est généralement comprise entre 0,067 et 0,67 Pa (0,5 et 5 mTorr).

Le rapport de flux molaire VI/III est généralement compris entre 3 et 4.

La durée de l'étape de croissance latérale est généralement comprise entre 5 et 120 minutes. Selon un exemple de réalisation particulier, les conditions de l'étape de croissance sont les suivantes :

- pression totale de la chambre : 0,67-2,7 kPa (5-20 Torr) ;
- pression partielle de TMGa : environ 0,13 Pa (1 mTorr) ;
- rapport flux molaire Se/Ga (VI/III) : environ 3-4 ;
- température : 600-640°C ;
- durée de croissance : 1000-2000 secondes.

Le procédé selon l'invention permet de réaliser une épitaxie par avancée à partir des marches des nuclei de GaSe et d'obtenir ainsi une couche de GaSe-2D à orientation unique et sans joints de grain.

La structure formée par le procédé comprend :

- un substrat de silicium d'orientation [111] dont la surface est une surface vicinale passivée 3 présentant des terrasses passivées 31 et au moins une marche passivée 32 entre deux terrasses passivées ;
- une couche 4 de GaSe-2D formée sur les terrasses passivées, et présentant une orientation unique sans parois d'antiphase.

L'angle de désorientation α de la surface vicinale 3 du substrat de silicium d'orientation [111] est inférieur ou égal à 0,1°.

De préférence, la structure l'orientation du GaSe par rapport à la surface de silicium est de

$([11\text{-}2]_{Si}//[11\text{-}20]_{GaSe}$ .

La structure ainsi obtenue est donc de haute qualité cristalline et permet son intégration dans des applications électroniques, optiques, énergique...

Le procédé utilisé peut être à large échelle et haut rendement, le rendant ainsi compatible avec une utilisation dans l'industrie.

La couche de GaSe 2D constituée peut fonctionner comme une couche tampon sur laquelle on peut faire croitre d'autres matériaux 2D par épitaxie de van der Waals, en utilisant par exemple la technique MOCVD. Ces autres matériaux 2D peuvent par exemple être choisis parmi d'autres semi-conducteurs III-VI tel que In-Se, GaS, GaTe ..., ou une combinaison de plusieurs matériaux III-VI, de façon à obtenir l'alignement de bandes correspondant au type de composant que l'on souhaite fabriquer (photodétecteur, LED, MOSFET, TFET et de manière générale tous les composants « more than moore »).

Ces couches supplémentaires peuvent ainsi croître, en relation d'épitaxie avec la couche de GaSe 2D, avec une seule orientation.

Au lieu d'un matériau 2D, il peut s'agir d'un matériau 3D, pouvant être : un matériau III-V tel que GaN, InGaN GaAs, GaSb ou une combinaison de plusieurs matériaux III-V, un matériau II-VI tel que CdHgTe ou une combinaison de plusieurs matériaux II-VI, ou encore un matériau IV-IV tel que SiGe ou Ge-Ge ou une combinaison de plusieurs matériaux IV-IV.

Sauf indication contraire ou évidente, les différents modes de réalisation peuvent être combinés. La présente invention n'est pas limitée aux modes de réalisation précédemment décrits mais s'étend à tout mode de réalisation entrant dans la portée des revendications.

Parmi les nombreuses applications de l'invention, on peut citer la microélectronique, la photonique, les capteurs, les technologies en relation avec la radiofréquence, les microsystèmes électromécaniques (MEMS), les composants pour l'internet des objets (Internet of Things), les chargeurs de batterie, les composants haute-tension, microprocesseurs, les mémoires statique et dynamique, le photovoltaïque et plus largement tout ce qui touche aux technologies « more than Moore » ou technologies dites dérivées, c'est-à-dire les technologies qui intègrent plusieurs fonctions sur une même puce de silicium.

**Revendications**

1. Procédé d'épitaxie de GaSe sur un substrat de silicium d'orientation [111] **caractérisé en ce qu'**il comprend :

    - une étape de sélection d'un substrat de silicium d'orientation [111], ledit substrat provenant d'une découpe d'un barreau (1) de silicium selon une direction de désorientation qui est une des trois directions cristallographiques [11-2], l'angle de désorientation ($\alpha$) étant inférieur ou égal à 0,1°, la surface du substrat obtenue formant une surface vicinale (2) présentant une pluralité de terrasses (21) et au moins une marche (22) entre deux terrasses (21) ;
    - une étape de passivation consistant en un dépôt d'un biplan atomique de gallium et de sélénium sur la surface vicinale (2) du substrat de silicium de manière à former une surface vicinale passivée (3) en silicium-gallium-sélénium (Si-Ga-Se), ladite surface vicinale passivée présentant une pluralité de terrasses passivées (31) et au moins une marche passivée (32) entre deux terrasses passivées ;
    - une étape de formation d'une couche de GaSe bidimensionnel par épitaxie sur la surface passivée (3), ladite étape de formation comprenant une étape de nucléation à partir de chaque marche passivée (32) et une étape de croissance latérale sur les terrasses passivées (31) des nuclei (41) obtenus lors de l'étape de nucléation.

2. Procédé selon la revendication 1, comprenant en outre une étape de traitement de la surface vicinale de manière à aplanir les terrasses (21) de ladite surface vicinale jusqu'à obtenir une rugosité sensiblement nulle sur les terrasses, ladite étape de traitement étant réalisée après l'étape de sélection du substrat et avant l'étape de passivation.

3. Procédé selon la revendication 2, l'étape de traitement consistant en un traitement thermique du substrat de silicium à haute température, supérieure à 800°C

4. Procédé selon l'une quelconque des revendications précédentes, l'étape de passivation consistant en un dépôt en phase vapeur avec des précurseurs organométalliques (MOCVD).

5. Procédé selon la revendication 4, les précurseurs organométalliques étant le TriMéthylGallium (TMGa) et le Di-isoPropylSelenium (DiPSe), la pression partielle de TMGa étant de préférence comprise entre 0,13 et 26,7 Pa (1 et 200 mTorr).

6. Procédé selon l'une quelconque des revendications 4 ou 5, l'étape de passivation étant réalisée à une température comprise entre 400 et 650°C, et pendant une durée comprise entre 2 et 30 secondes.

7. Procédé selon l'une quelconque des revendications 1 à 6, l'étape de nucléation consistant en un dépôt en phase vapeur avec des précurseurs organométalliques, la pression partielle du précurseur du gallium étant inférieure ou égale à 6,7 Pa (50 mTorr).

8. Procédé selon la revendication 7, l'étape de nucléation étant réalisée à une température comprise entre 400 et 650°C.

9. Procédé selon l'une quelconque des revendications 7 ou 8, l'étape de nucléation étant réalisée pendant une durée comprise entre 2 et 30 secondes.

10. Procédé selon l'une quelconque des revendications 1 à 9, l'étape de croissance latérale consistant en un dépôt en phase vapeur avec des précurseurs organométalliques, la pression partielle du précurseur du gallium étant comprise entre 0,067 et 0,67 Pa (0,5 et 5 mTorr).

11. Procédé selon la revendication 10, l'étape de croissance latérale étant réalisée à une température comprise entre 570 et 650°C.

12. Procédé selon l'une quelconque des revendications précédentes comprenant en outre une étape de retrait de l'oxyde de la surface vicinale (2), ladite étape de désoxydation étant réalisée après l'étape de sélection du substrat et avant l'étape de passivation.

13. Procédé selon l'une quelconque des revendications précédentes, comprenant en outre une étape supplémentaire d'épitaxie d'au moins un matériau 2D autre que le GaSe-2D ou d'au moins un matériau semi-conducteur 3D, ladite étape supplémentaire d'épitaxie étant formée sur la couche de GaSe-2D.

14. Procédé selon la revendication 13, le au moins un matériau 2D autre que le GaSe-2D ou le au moins un matériau 3D étant choisi parmi les matériaux III-VI tels que le InSe, GaS, GaTe ou une combinaison de matériaux III-VI, les matériaux III-V tels que le GaN, InGaN, GaAs, GaSb ou une combinaison de matériaux III-V, les matériaux II-VI tels que CdHgTe ou une combinaison de matériaux II-VI, ou encore les matériaux IV-IV tels que SiGe ou Ge-Ge ou une combinaison de matériaux IV-IV.

15. Structure obtenue par le procédé d'épitaxie de GaSe sur un substrat de silicium d'orientation [111] selon l'une des revendications 1 à 14 comprenant :

- un substrat de silicium d'orientation [111] dont la surface est une surface vicinale passivée (3) présentant des terrasses passivées (31) et au moins une marche passivée (32) entre deux terrasses passivées, l'angle de désorientation (α) de la surface vicinale (3) étant inférieur ou égal à 0,1°, la direction de désorientation est selon l'une des trois directions cristallographiques [11-2] ;
- une couche (4) de GaSe-2D formée sur les terrasses passivées, et présentant une orientation unique sans parois d'antiphase.

**Patentansprüche**

1. Verfahren zum Epitaxieren von GaSe auf einem Siliciumsubstrat mit der Orientierung [111], **dadurch gekennzeichnet, dass** es Folgendes umfasst:

- einen Schritt des Auswählens eines Siliciumsubstrats mit der Orientierung [111], wobei das Substrat vom Schneiden eines Siliciumstabs (1) entlang einer Desorientierungsrichtung stammt, die eine der drei kristallographischen Richtungen [11-2] ist, wobei der Desorientierungswinkel (α) gleich oder kleiner 0,1° ist, wobei die erhaltene Oberfläche des Substrats eine vicinale Oberfläche (2) mit einer Vielzahl von Terrassen (21) und mindestens einer Stufe (22) zwischen zwei Terrassen (21) bildet;
- einen Passivierungsschritt bestehend aus dem Abscheiden einer atomaren Gallium- und Selen-Doppelebene auf der vicinalen Oberfläche (2) des Siliciumsubstrats, um eine passivierte vicinale Oberfläche (3) aus Silicium-Gallium-Selen (Si-Ga-Se) zu bilden, wobei die passivierte vicinale Oberfläche eine Vielzahl von passivierten Terrassen (31) und mindestens eine passivierte Stufe (32) zwischen zwei passivierten Terrassen aufweist;
- einen Schritt des Bildens einer zweidimensionalen GaSe-Schicht durch Epitaxie auf der passivierten Oberfläche (3), wobei der Bildungsschritt einen Nukleierungsschritt ab jeder passivierten Stufe (32) und einen Schritt des lateralen Aufwachsenlassens der im Nukleierungsschritt erhaltenen Nuklei (41) auf den passivierten Terrassen (31) beinhaltet.

2. Verfahren nach Anspruch 1, das ferner einen Schritt des Behandelns der vicinalen Oberfläche beinhaltet, um die Terrassen (21) der vicinalen Oberfläche zu ebnen, bis eine Rauheit von im Wesentlichen null auf den Terrassen erreicht ist, wobei der Behandlungsschritt nach dem Substratauswahlschritt und vor dem Passivierungsschritt durchgeführt wird.

3. Verfahren nach Anspruch 2, wobei der Behandlungsschritt aus einer Wärmebehandlung des Siliciumsubstrats bei einer hohen Temperatur von über 800 °C besteht.

4. Verfahren nach einem der vorhergehenden Ansprüche, wobei der Passivierungsschritt aus einer Dampfphasenabscheidung mit organometallischen Vorläufern (MOCVD) besteht.

5. Verfahren nach Anspruch 4, wobei die organometallischen Vorläufer TriMethylGallium (TMGa) und Di-isoPropylSelen (DiPSe) sind und der Partialdruck von TMGa vorzugsweise zwischen 0,13 und 26,7 Pa (1 und 200 mTorr) liegt.

6. Verfahren nach Anspruch 4 oder 5, wobei der Passivierungsschritt bei einer Temperatur zwischen 400 und 650 °C und für eine Dauer zwischen 2 und 30 Sekunden durchgeführt wird.

7. Verfahren nach einem der Ansprüche 1 bis 6, wobei der Nukleierungsschritt aus einer Dampfphasenabscheidung mit organometallischen Vorläufern besteht, wobei der Partialdruck des Galliumvorläufers gleich oder kleiner 6,7 Pa (50 mTorr) ist.

8. Verfahren nach Anspruch 7, wobei der Nukleierungsschritt bei einer Temperatur zwischen 400 und 650 °C durchgeführt wird.

9. Verfahren nach Anspruch 7 oder 8, wobei der Nukleierungsschritt für eine Dauer zwischen 2 und 30 Sekunden durchgeführt wird.

10. Verfahren nach einem der Ansprüche 1 bis 9, wobei der Schritt des lateralen Aufwachsenlassens aus einer Dampfphasenabscheidung mit organometallischen Vorläufern besteht, wobei der Partialdruck des Galliumvorläufers zwischen 0,067 und 0,67 Pa (0,5 und 5 mTorr) liegt.

11. Verfahren nach Anspruch 10, wobei der Schritt des lateralen Aufwachsenlassens bei einer Temperatur zwischen 570 und 650 °C durchgeführt wird.

12. Verfahren nach einem der vorhergehenden Ansprüche, das außerdem einen Schritt des Entfernens des Oxids von der vicinalen Oberfläche (2) umfasst, wobei der Desoxidationsschritt nach dem Substratauswahlschritt und vor dem Passivierungsschritt durchgeführt wird.

13. Verfahren nach einem der vorhergehenden Ansprüche, das ferner einen zusätzlichen Schritt des Epitaxierens von mindestens einem 2D-Material, das nicht GaSe-2D ist, oder von mindestens einem 3D-Halbleitermaterial umfasst, wobei der zusätzliche Epitaxieschritt auf der GaSe-2D-Schicht gebildet wird.

14. Verfahren nach Anspruch 13, wobei das mindestens eine 2D-Material, das nicht GaSe-2D ist, oder das mindestens eine 3D-Material ausgewählt wird aus III-VI-Materialien wie InSe, GaS, GaTe oder einer Kombination von III-VI-Materialien, III-V-Materialien wie GaN, InGaN, GaAs, GaSb oder einer Kombination von III-V-Materialien, II-VI-Materialien wie CdHgTe oder einer Kombination von II-VI-Materialien oder IV-IV-Materialien wie SiGe oder Ge-Ge oder einer Kombination von IV-IV-Materialien.

15. Struktur, die mit dem Verfahren des Epitaxierens von GaSe auf einem Siliciumsubstrat mit der Orientierung [111] nach einem der Ansprüche 1 bis 14 erhalten wurde, die Folgendes umfasst:

   - ein Siliciumsubstrat mit der Orientierung [111], dessen Oberfläche eine passivierte vicinale Oberfläche (3) mit passivierten Terrassen (31) und mindestens einer passivierten Stufe (32) zwischen zwei passivierten Terrassen ist, wobei der Desorientierungswinkel ($\alpha$) der vicinalen Oberfläche (3) gleich oder kleiner 0,1° ist, die Desorientierungsrichtung liegt in einer der drei kristallographischen Richtungen [11-2];
   - eine Schicht (4) aus GaSe-2D, die auf den passiven Terrassen gebildet wird und eine einzige Orientierung ohne Antiphasenwände aufweist.

**Claims**

1. Process for epitaxying GaSe on a [111]-oriented silicon substrate, **characterized in that** it comprises:

   - a step of selecting a [111]-oriented silicon substrate, said substrate resulting from cutting a silicon bar (1) in a miscut direction which is one of the three [11-2] crystallographic directions, the miscut angle ($\alpha$) being smaller than or equal to 0.1°, the obtained surface of the substrate forming a vicinal surface (2) exhibiting a plurality of terraces (21) and at least one step (22) between two terraces (21);
   - a passivation step consisting of depositing an atomic bilayer of gallium and of selenium on the vicinal surface (2) of the silicon substrate so as to form a passivated vicinal surface (3) made of silicon-gallium-selenium (Si-Ga-Se), said passivated vicinal surface exhibiting a plurality of passivated terraces (31) and at least one passivated step (32) between two passivated terraces;
   - a step of forming a layer of two-dimensional GaSe by epitaxy on the passivated surface (3), said formation step comprising a step of nucleation from each passivated step (32) and a step of lateral growth on the passivated terraces (31) of the nuclei (41) obtained in the nucleation step.

2. Process according to Claim 1, further comprising a step of treating the vicinal surface so as to flatten the terraces (21) of said vicinal surface until a substantially zero roughness is obtained on the terraces, said treatment step being carried out after the substrate selection step and before the passivation step.

**3.** Process according to Claim 2, the treatment step consisting of heat-treating the silicon substrate at high temperature, higher than 800°C.

**4.** Process according to any one of the preceding claims, the passivation step consisting of chemical vapour deposition with metal-organic precursors (MOCVD).

**5.** Process according to Claim 4, the metal-organic precursors being trimethylgallium (TMGa) and diisopropyl selenide (DiPSe), the partial pressure of TMGa preferably being between 0.13 and 26.7 Pa (1 and 200 mTorr).

**6.** Process according to either of Claims 4 and 5, the passivation step being carried out at a temperature of between 400 and 650°C, and for a duration of between 2 and 30 seconds.

**7.** Process according to any one of Claims 1 to 6, the nucleation step consisting of metal-organic chemical vapour deposition with metal-organic precursors, the partial pressure of the gallium precursor being lower than or equal to 6.7 Pa (50 mTorr).

**8.** Process according to Claim 7, the nucleation step being carried out at a temperature of between 400 and 650°C.

**9.** Process according to either of Claims 7 and 8, the nucleation step being carried out for a duration of between 2 and 30 seconds.

**10.** Process according to any one of Claims 1 to 9, the lateral growth step consisting of chemical vapour deposition with metal-organic precursors, the partial pressure of the gallium precursor being between 0.067 and 0.67 Pa (0.5 and 5 mTorr).

**11.** Process according to Claim 10, the lateral growth step being carried out at a temperature of between 570 and 650°C.

**12.** Process according to any one of the preceding claims, further comprising a step of removing the oxide from the vicinal surface (2), said deoxidation step being carried out after the substrate selection step and before the passivation step.

**13.** Process according to any one of the preceding claims, further comprising an additional step of epitaxying at least one 2D material other than 2D GaSe or at least one 3D semiconductor material, said additional step of epitaxy being formed on the layer of 2D GaSe.

**14.** Method according to Claim 13, the at least one 2D material other than 2D GaSe or the at least one 3D material being chosen from the III-VI materials such as InSe, GaS, GaTe or a combination of III-VI materials, the III-V materials such as GaN, InGaN, GaAs, GaSb or a combination of III-V materials, the II-VI materials such as CdHgTe or a combination of II-VI materials, or the IV-IV materials such as SiGe or Ge-Ge or a combination of IV-IV materials.

**15.** Structure obtained by means of the process for epitaxying GaSe on a [111]-oriented silicon substrate according to one of Claims 1 to 14, comprising:

- a [111]-oriented silicon substrate, the surface of which is a passivated vicinal surface (3) exhibiting passivated terraces (31) and at least one passivated step (32) between two passivated terraces, the miscut angle ($\alpha$) of the vicinal surface (3) being smaller than or equal to 0.1°, the miscut direction being one of the three [11-2] crystallographic directions;
- a layer (4) of 2D GaSe formed on the passivated terraces, and exhibiting a single orientation without antiphase boundaries.

[Fig. 1A]

Vue de côté

Se
Ga
Si

Orientation 1

Vue de dessus

Se
Ga
Si

[Fig 1B]

Vue de côté

Se
Ga
Si

Orientation 2

Vue de dessus

Ga
Se
Si

[Fig 2]

Orientation 2

5

Orientation 1

[Fig 3A]

[1-10]

[11-2]        [11-2]

1

Si [111]

[11-2]

11

13          12

[Fig 3B]

[Fig 3C]

[Fig 3D]

[Fig 3E]

[Fig 3F]

[Fig 3G]

Vue de dessous

Vue de côté

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- *Extended Abstracts of the 1992 International Conference on Solid State Devices and Materials, Tsukuba,* 1992, 302-303

- *Journal of Crystal Growth,* 1994, vol. 135, 1-10